(19) Europäisches Patentamt

European Patent Office

Office européen des brevets

(11) EP 1 018 632 A2

(12) EUROPEAN PATENT APPLICATION

(43) Date of publication:
12.07.2000 Bulletin 2000/28

(51) Int. Cl.$^7$: G01B 11/22

(21) Application number: 99126272.6

(22) Date of filing: 31.12.1999

(84) Designated Contracting States:
AT BE CH CY DE DK ES FI FR GB GR IE IT LI LU
MC NL PT SE
Designated Extension States:
AL LT LV MK RO SI

(30) Priority: 06.01.1999 US 226459

(71) Applicants:
• International Business Machines Corporation
Armonk, NY 10504 (US)
• Siemens Aktiengesellschaft
80506 München (DE)

(72) Inventors:
• Halle, Scott D.
Hopewell Junction, NY 12533 (US)
• Mantz, Ulrich
Poughkeepsie, NY 12601 (US)
• Mueller, K.Paul
Wappingers Falls, NY 12590 (US)
• Jaiprakash, Venkatachalam C.
Beacon, NY 12508 (US)

(74) Representative:
Teufel, Fritz, Dipl.-Phys. et al
IBM Deutschland Informationssysteme GmbH,
Intellectual Property,
Pascalstrasse 100
70548 Stuttgart (DE)

(54) **Non-destructive method and device for measuring the depth of a recessed material**

(57) A non-destructive method for measuring depth of recessed semiconductor material deposited within a trench formed in a semiconductor substrate. The semiconductor substrate containing the trench filled with the recessed semiconductor material is illuminated with infrared radiation. The spectral content of a return signal is detected and analyzed. The spectral content of the return signal is correlated to theoretical sample spectra to thereby determine the depth of the recessed semiconductor material.

FIG. 3

EP 1 018 632 A2

**Description**

Field of the Invention

The present invention is concerned with a non-destructive method for measuring the depth of recessed material below the surface in a semiconductor substrate. More particularly, the present invention is related to non-destructively measuring the depth of recessed semiconductor material in a trench formed in a semiconductor substrate. The non-destructive method of the present invention employs Fourier Transform Infrared (FTIR) measurements to detect the depth of the recessed semiconductor material below the surface of a semiconductor substrate. The present invention is also concerned with devices for measuring the depth of recessed semiconductor material in a semiconductor substrate.

Background of the Invention

High processing speed in currently available data processors must be supported by large amounts of high speed random access memory. Due to reduced device counts per memory cell, much of the required storage is provided by dynamic random access memories (DRAMs). DRAM's permit a significantly greater number of memory cells can be provided on a single integrated circuit chip.

In DRAM devices, the density at which memory cells, principally comprising one storage capacitor per memory cell, are formed is of great importance. This is because the capacitance of each capacitor is very limited due to small size. However, that capacitance must be large compared to the capacitance of the word line and bit line to achieve adequate operating margins for the sense amplifiers used to detect the presence or absence of stored charge. Therefore, the trenches utilized in DRAM devices are formed to relatively large depths while being very closely spaced. These same geometries are also important for other trench structures such as isolation trenches.

At a certain point in the process of creating such devices, certain materials may be deposited in the deep trenches. For example, it may be desirable to deposit polycrystalline silicon in the trenches.

Currently, measuring the depth of recessed material in a trench can only be carried out destructively by cross-section and microscopic imaging of random samples. Accordingly, providing a practical and non-destructive procedure for determining the depth of recessed semiconductor or other material located in a trench would represent a significant advance.

Summary of the Invention

The present invention provides a non-destructive method for measuring the depth of the top surface of recessed semiconductor material in a trench formed in a semiconductor substrate. According to the present invention, the depth of the recessed semiconductor material can be determined without destructively cross-sectioning.

In particular, the present invention is concerned with a non-destructive method for measuring depth of recessed semiconductor material deposited within a trench formed in a semiconductor substrate. According to the method, the semiconductor substrate containing the trench filled with the recessed semiconductor material is illuminated with infrared radiation. The spectral content of a return signal is detected and analyzed. The spectral content of the return signal is correlated to theoretical sample spectra to thereby determine the depth of the recessed semiconductor material.

The present invention is also concerned with a device for measuring depth of recessed semiconductor material deposited within a trench formed in a semiconductor substrate. The device includes a Fourier Transform infrared spectrophotometer that illuminates the substrate with a source of infrared radiation and produces a Fourier transform of a return signal reflected from the substrate. A processor generates theoretical sample spectra and correlates the spectral content of the return signal to theoretical sample spectra to thereby determine the depth of the recessed semiconductor material.

Still other objects and advantages of the present invention will become readily apparent by those skilled in the art from the following detailed description, wherein it is shown and described only the preferred embodiments of the invention, simply by way of illustration of the best mode contemplated of carrying out the invention. As will be realized, the invention is capable of other and different embodiments, and its several details are capable of modifications in various obvious respects, without departing from the invention. Accordingly, the drawings and description are to be regarded as illustrative in nature and not as restrictive.

Brief Description of the Drawings

The above-mentioned objects and advantages of the present invention will be more clearly understood when considered in conjunction with the accompanying drawings, in which:

Fig. 1 represents a cross-sectional view of an example of a structure that the present invention may be utilized to measure the depth of;

Figs. 2a-d represent graphs of curves illustrating a relationship between spectral content of unknown samples and wavelengths of infrared radiation utilized to measure recess depth and results of an embodiments of methods for analyzing the spectral content data and estimating recess depth;

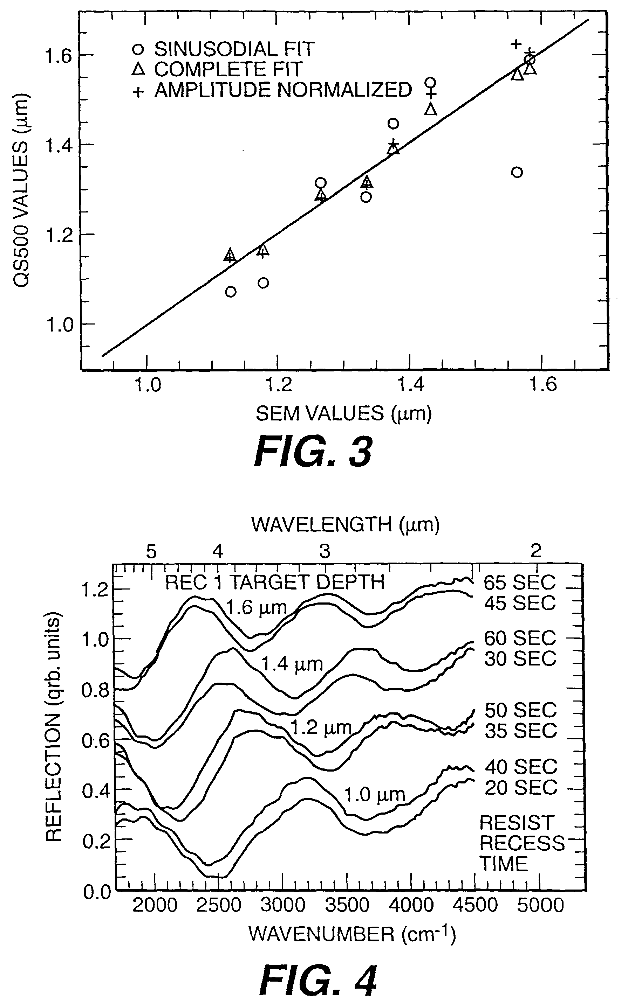

Fig. 3 represents a graph that compares measurements with and without normalization obtained according to the present invention compared to values measured from examining cross-sections of the structures with a scanning electron microscope; and

Fig. 4 represents a graph illustrating reflectometry spectra for a matrix of recess depth and buried plated depth.

Best and Various Modes for Carrying Out Invention

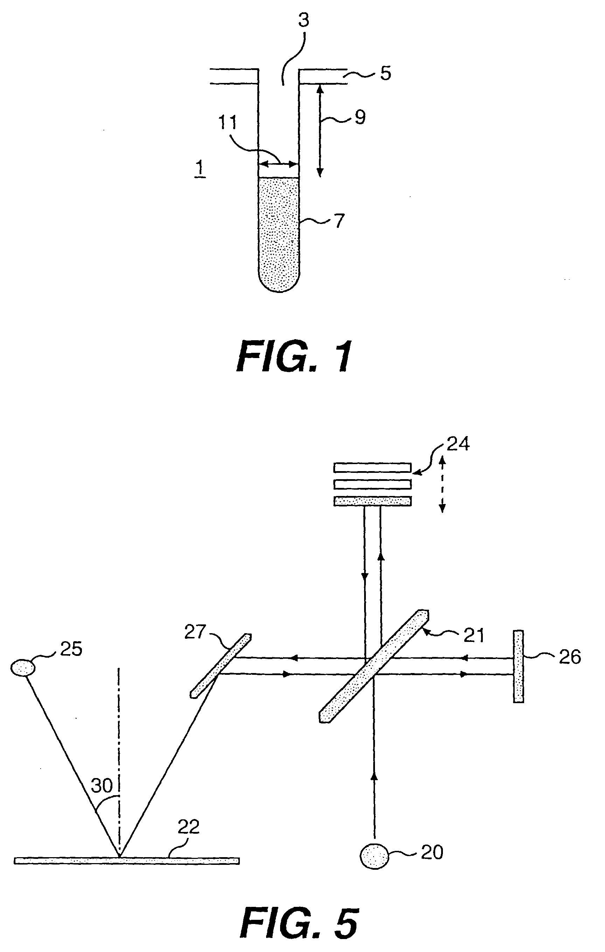

Referring now to the drawings, Fig. 1 illustrates a typical structure that the present invention may be utilized in characterizing. The structure illustrated in Fig. 1 includes a substrate 1. Typically, the substrate is monocrystalline silicon. A trench 3 has been formed in the substrate 1. A layer of a material 5 has been deposited on the surface of the substrate 1. Examples of the material 5 include dielectric materials.

The trench 3 may be filled with material 7. The composition of material 7 may depend upon the stage of the process. At some stages, material 7 may be photoresist. At other times, material 7 may be polycrystalline silicon. Although it may be utilized in a variety of applications, the present invention is particularly concerned with measuring the depth of recessed polycrystalline silicon material in the trench.

As can be seen in Fig. 1, the upper surface of material 7 has been recessed below the upper surface of the substrate 1 as well as material layer 5 on the substrate. The present invention is particularly concerned with measuring the depth 9 that the polycrystalline silicon or other material is recessed below the upper surface of the substrate. At any particular depth, the trench and, hence, any material filling the trench will have a width 11.

For purposes of simplicity and to further facilitate an understanding of the present invention, the following discussion is directed to recessed polycrystalline silicon deposited in a trench formed in a monocrystalline substrate. It should be understood, of course, that the present invention is applicable for measuring the depth of other structures.

The present invention may be particularly useful in detecting depth of recessed polycrystalline silicon material in a trench in a monocrystalline substrate because of the similarities in the properties of polycrystalline silicon and monocrystalline silicon.

A typical FTIR system is available from Bio-Rad Laboratories under the trade designation Bio-Rad QS500. Fig. 5 illustrates a schematic of the FTIR set up.

In particular, a FTIR system is an instrument that emits a controlled infrared spectrum and detects and analyzes the spectral content of a return signal by Fourier analysis. As illustrated in Fig. 5, an IR source 20 is provided to emit broadband infrared energy. For example, the IR energy may be have wave numbers of between about 400 and about 4500. The wavelength of such IR energy is in a range of from about 25 microns to about 2 microns. One example of an IR source that may be utilized according to the present invention is a Globar IR source.

An interferometer typically is located in the path from the IR source 20 to sample 22. The interferometer typically includes moving mirror 24, fixed mirror 26 and beam splitter 21. The interferometer typically utilizes a moving mirror 24 to produce constructive and destructive interference patterns at detector 25. These patterns may depend upon the frequency or wave number of the detected light and/or the characteristics of the sample. One example of an interferometer that may be utilized according to the present invention is a Michaelson interferometer.

Mirrors 26 and 27 may be utilized to direct the path of the light from the source to the sample. Circuitry (not shown) may be provided for performing a Fourier transform of the return signal arriving at detector 25. A detailed description of such circuitry is not necessary since persons skilled in the art, once aware of this disclosure, could provide such without undue experimentation. The operations performed by the circuitry may vary, depending upon the embodiment. Various algorithms for analyzing the data are described below.

In the case the depth of recessed semiconductor material is being measured, the portion of the spectrum between about 2000 and about 5000 wave numbers has been found useful in obtaining such information. Some of the possible reasons for this are as follows. A silicon substrate is transparent to light with wavenumbers between about $2000cm^{-1}$ and about $5000cm^{-1}$. In addition, the horizontal width of the trench structure is smaller than the wavelength of the IR light. Therefore, the structures typically cannot be resolved by the IR radiation. The IR light propagates in trench patterned areas of the substrate in like manner as it would through a homogeneous film.

The refractive index of the film can be calculated by the effective medium theory. In the context of the present invention, such as measuring trench structures, the refractive index of the 'effective trench film' is lower than the refractive index of silicon. When light passes an interface of films with different optical properties, a portion of the light is reflected.

In the context of the present invention, important interfaces may include the interface between the unfilled and the filled area of the trench and the interface between the top silicon surface and the dielectric layer on top of it. The reflected light from both interfaces interferes and the recess depth can be calculated using Fresnel's equations. For deep recess structures, such as recesses greater than about 0.5 µm, the reflectance signal contains oscillations.

The frequency of these oscillations is proportional to the depth of the recess. According to the present invention, it has been found that different depths of recessed material cause very distinct patterns in the 2000 to 5000 wavenumber portion of the spectrum. According to the present invention, the unknown sample is illuminated with the IR light and the spectral content of the return signal is analyzed. Then, a comparison is made to determine a theoretical, mathematically generated calibration spectrum which most closely matches the analyzed return signal. The theoretical spectrum that most closely matches the unknown spectrum indicates the depth of the recessed semiconductor material.

In some embodiments, empirically determined calibration spectra may be utilized rather than experimentally determined ones. In this case, the empirically determined curves may be contained in a library. The experimental curves may be compared to the empirically derived curves to determine the best fit with any suitable comparison method, such as the least square method described herein in detail. However, by being able to utilize theoretically derived spectra, the present invention may eliminate the need for conducting initial calibration measurements or for maintaining correlation spectra in libraries.

According to one aspect of the present invention, for maximizing the comparison, both the unknown sample spectra and the theoretical calibration spectra may be truncated at about 1700 cm$^{-1}$ and at about 4200 cm$^{-1}$.

The data resulting from FTIR operation may be analyzed according to a variety of processes. According to one embodiment, analyzing the spectral data from the sample to find the matching mathematically generated theoretical spectrum can be performed by a least squares comparison of the unknown spectrum to the mathematically generated theoretical spectra. For example, SUM i = 1 to i = n of corresponding points $(a_i-b_i)^2$ along each curve may be used to find the minimum sum. In other words, the least square fit procedure involves calculating the difference for each wave number and each theoretical spectrum; squaring the difference for each wave number and each theoretical spectrum; summing the squares for all wave numbers and each theoretical spectrum; and determining the minimum of all sums. The minimum is found for the best fitting theoretical spectrum and the spectrum corresponding to the unknown sample depth of the recessed semiconductor of the unknown sample. Of course, other correlation methods can be used if desired such as by calculating the covariance "COV" or the Correlation Coefficient $\rho_{xy}$ as described in Users' Guide Microsoft$^{®}$ Excel.

The Covariance tool returns the average of the product of deviations of data points from their respective means. Covariance is a measure of the relationship between two ranges of data.

$$cov(X,Y)=\frac{1}{n}\Sigma\ (x_i-\mu_x)(y_i-\mu_y)$$

wherein $\mu_x$ is the mean value of x-data set and $\mu_y$ is the mean value of y-data set.

The Correlation tool measures the relationship between two data sets that are scaled to be independent of the unit of measure. The population correlation calculation returns the covariance of two data sets divided by the product of their standard deviations.

$$\rho_{x,y}=\frac{cov(X,Y)}{\sigma_x\bullet\sigma_y}$$

where $\sigma_y$ is standard deviation of y-data set;
where $\sigma_x$ is standard deviation of x-data set; where

$$\sigma_x^2=\frac{1}{n}\Sigma(X_I-\mu_x)^2$$

and

$$\sigma_y^2=\frac{1}{n}\Sigma(Y_I-\mu_y)^2$$

According to one embodiment of the present invention for analyzing data resulting from FTIR operation, a curve is obtained by plotting the reflectivity measurements with respect to the corresponding wavelength. After plotting the experimental curve from the return spectra, a variety of steps may be carried out to analyze the experimental data and generate theoretical models to compare to the experimental data to determine the depth of the recessed semiconductor material. These steps may include generating additional curves from the experimental data.

According to one embodiment, the experimental data may be correlated with a theoretical model. According to one embodiment, the theoretical model may be defined by the following function:

$$R(x)=B(x)+(mx+k)\sin(f(x)+\varphi),$$

wherein B(x) is a second order polynomial, m and k are constants, and x is the wavenumber of the infrared radiation, and where f(x) is proportional to the index of refraction and depth of the recessed semiconductor material.

For recess 1 measurements, such as for recesses having a depth of greater than about 0.5μm, the depth information can be determined from the frequency of the oscillation. Typically, only a few periods of the oscillations can be observed in the selected spectral range of the IR radiation. Therefore, a simple function, which might be an approximation, can be used to describe the reflectance spectrum. Since a correct physical model is not required in order to obtain the frequency, fit parameters can be introduced to account for different features in the spectrum. Fit parameters may include:

B (x) :  polynomial background for the offset and very low frequency changes in the spectra;

M and k:  amplitude of the oscillation, which can change with the wavenumber for various reasons;

F (x) :  frequency of the oscillation; and

φ:  Phase shift of the oscillation.

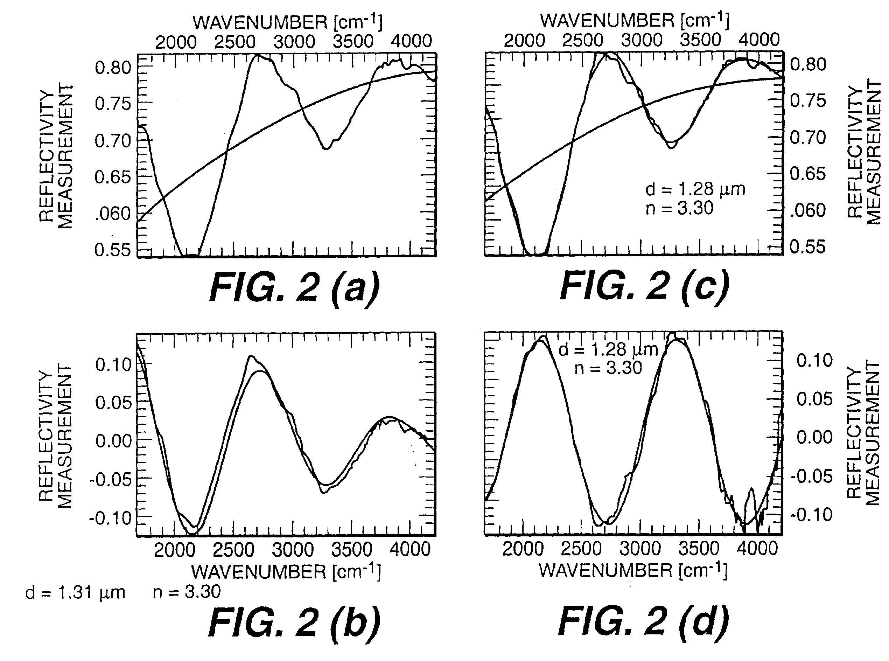

As illustrated in Fig. 2(a), a second order polynomial may be generated based upon the waveform R(x) resulting from the experimental data. In the case illustrated in Fig. 2(a), the second order polynomial represents a second order background fit polynomial B'(x). In Fig. 2(a), the polynomial B'(x) is shown superimposed on the test waveform and represents the best background fit polynomial.

In analyzing the test data, B'(x) may be subtracted from the test waveform R(x) to yield a sine curve $(mx+k)\sin f(x)$ . It is a goal in this embodiment of the method of the present invention that B(x) in the test waveform equal B'(x), the mathematically generated polynomial that is subtracted from the test waveform.

The function B'(x) may be generated in a variety of manners. According to one example, B'(x) is generated based upon predictable parameters. The process of fitting the functions B'(x) and B(x) may be carried out with a least squares analysis described above in detail. The fits in one example may be separate for the background and the sinusoidal function. In another example, the fit may include all parameters at once. After generating B'(x), and fitting it with the test data, the depth of the recessed material may then be determined based upon the above-identified function R(x).

Fig. 2(b) illustrates another analysis that may be performed on the test data according to the present invention. In Fig. 2(b), the background fit polynomial B'(x) has been subtracted from the test waveform resulting from irradiating the test sample. The non-smooth curve shown in Fig. 2(b) is the test waveform minus the fit polynomial B'(x), i.e. R(x)-B'(x).

The other curve represented in Fig. 2(b) is a stored or mathematically generated fit curve of the form $(m'x+b')\sin(f'(x)+\varphi)$ . The two curves may be superimposed as shown in Fig. 2(b) to compare them so as to provide a rough determination of the best fitting theoretical curve. A more accurate comparison may be provided by carrying out a fitting process. Any suitable fitting process may be utilized, such as the least squares method described above.

Fig. 2(c) represents another alternative method for analyzing the test data. According to the method illustrated in Fig. 2(c), a background fit polynomial B'(x) is not subtracted from the test waveform prior to comparing the test waveform to a fit waveform. In this method, the test waveform is fitted directly to a fit waveform which is described mathematically as the function $R'(x)=B''(x)+(m'x+b')\sin(f'(x))$ .

This function R'(x) is shown as the smooth curve in FIG. 2(c). In this function, B''(x) is not quite the same as B'(x). Along these lines, B''(x) may not be perfectly described by a second order polynomial fit. One manifestation of the differences between B''(x) and B'(x) is the slightly different background curve that represents B''(x). Compare B''(x) in Fig. 2(c) to B'(x) shown in FIG. 2(b). One reason for the differences in the curves is that the background curve defined by B''(x) might not be perfectly described by a second order polynomial.

The method described and shown in Fig. 2(c) may be carried further, as illustrated in Fig. 2(d). FIG. 2d shows the test waveform R(x) and the best fit curve R'(x) after both waveforms have been normalized by dividing by m'(x). While fitting the test waveform to a background polynomial is typically insufficient to determine the depth of recessed material, the periodicity of the waveform defined as the frequency f(x) may be of primary importance. By normalizing the curve, more weight may be accorded to higher wavenumber receptions, making it possible to determine a closer fit.

All parameters in the function R(x) may be required in order to obtain a good fit. However, f(x) alone may contain the depth information. According to another method of obtaining f(x), a power spectrum is derived from R(x) by a Fourier transformation. The frequency f would be represented by a peak maximum at a frequency $f_0$.

For deep recesses, such as recesses having depths of greater than about 0.5μm, the depth can be calculated from the frequency of the oscillation. On the other hand, for shallow oscillations, the Fresnel equation may be utilized.

The foregoing description of the invention illustrates and describes the present invention. Additionally, the disclosure shows and describes only the preferred embodiments of the invention, but as aforementioned, it is to be understood that the invention is capable of use in various other combinations, modifications, and environments and is capable of changes or modifications within the scope of the inventive concept as expressed herein, commensurate with the above teachings, and/or the skill or knowledge of the relevant art. The embodiments described herein above are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments.

**Claims**

1.  A non-destructive method for measuring depth of recessed semiconductor material deposited within a trench formed in a semiconductor substrate, the method comprising the steps of:

    illuminating with infrared radiation the semiconductor substrate containing the trench filled with the recessed semiconductor material;

    detecting and analyzing the spectral content of a return signal; and

    correlating the spectral content of the return signal to theoretical sample spectra to thereby determine the depth of the recessed semiconductor material.

2.  The method according to claim 1, wherein the recessed semiconductor material is polycrystalline silicon and the semiconductor substrate is monocrystalline silicon.

3.  The method according to claim 1, wherein analysis of the spectral content of the return signal is carried out by Fourier analysis.

4.  The method according to claim 1, wherein the infrared radiation has wavenumbers between about 2000 cm$^{-1}$ and about 5000 cm$^{-1}$.

5.  The method according to claim 1, wherein the depth of the recessed semiconductor material is greater than about 0.5 $\mu$m.

6.  The method according to claim 1, wherein the correlating includes comparing a curve representing the spectral content of the return signal to a curve representing the theoretical sample spectra.

7.  The method according to claim 6, wherein the curves representing the return signal and the theoretical sample spectra represent relationships between reflectivity and wavelength.

8.  The method according to claim 7, wherein the curves representing the return signal and the theoretical sample spectra are periodically related to the depth of the top of the recessed semiconductor material.

9.  The method according to claim 7, wherein the curve representing the calibration spectra is ideal.

10. The method according to claim 5, wherein spectral content of the return signal is correlated with the theoretical spectra according to the following formulae to determine the depth of the recessed semiconductor material:

    $$R(x)=B(x)+(mx+k)\sin(f(x)),$$

    where B(x) is a second order polynomial, m and k are constants, and x is the wavenumber of the infrared radiation, and where f(x) is proportional the index of refraction and depth of the recessed semiconductor material.

11. The method according to claim 7, wherein the curve representing the spectral content of the return signal and the curve representing the theoretical sample spectra are fit with a least squares method.

12. The method according to claim 7, wherein the curve representing the theoretical sample spectra is a mathematically generated second order polynomial, the method further comprising the step of:

    subtracting the second order polynomial from the curve representing the spectral content of the return signal.

13. The method according to claim 12, wherein the second order polynomial is mathematically generated from the curve representing the spectral content of the return signal.

14. The method according to claim 12, further comprising the steps of:

    mathematically generating a fit waveform curve; and
    comparing the fit curve to the curve generated by subtracting the second order polynomial from the curve representing the spectral content of the return signal.

15. The method according to claim 7, further comprising the steps of:

    mathematically generating a fit waveform curve; and
    comparing the fit curve to the curve representing the spectral content of the return signal.

16. The method according to claim 15, further comprising the steps of:

    mathematically generating a second order polynomial from the curve representing the spectral content of the return signal;

subtracting the second order polynomial from the curve representing the spectral content of the return signal;

normalizing the fit waveform and the curve resulting from subtracting the second order polynomial from the curve representing the spectral content of the return signal; and

comparing the fit waveform to the curve resulting from subtracting the second order polynomial from the curve representing the spectral content of the return signal.

17. A device for measuring depth of recessed semiconductor material deposited within a trench formed in a semiconductor substrate, comprising:

a spectrophotometer that illuminates the substrate with a source of infrared radiation and produces a transformation of a return signal reflected from the substrate;

a processor for generating theoretical sample spectra and correlating the spectral content of the return signal to theoretical sample spectra to thereby determine the depth of the recessed semiconductor material.

18. The device according to claim 17, wherein the source of infrared light is a source of broadband infrared radiation.

19. The device according to claim 17, wherein the infrared radiation has wavenumbers between about 2000 cm$^{-1}$ and about 5000 cm$^{-1}$.

20. The device according to claim 17, wherein the processor compares a curve representing the spectral content of the return signal to a curve representing the theoretical sample spectra.

21. The device according to claim 20, wherein the curves representing the spectral content from the sample and the theoretical sample spectra represent intensity versus wavelength.

22. The device according to claim 20, wherein the curves representing the spectral content from the sample and the theoretical sample spectra are periodically related to the depth of the recessed semiconductor material.

23. The device according to claim 20, wherein the curves representing the spectral content from the sample and the theoretical sample spectra are based upon the indices of refraction of the material in the semiconductor substrate and the depth of the recessed semiconductor material.

24. The device according to claim 20, wherein the curve representing the calibration spectra is ideal.

25. The device according to claim 17, wherein the processor correlates the spectral content of the return signal with the theoretical spectra according to the following formulae to determine the depth of the recessed semiconductor material:

$$R(x)=B(x)+(mx+k)\sin(f(x)),$$

where B(x) is a second order polynomial, m and k are constants, and x is the wavenumber of the infrared radiation, and where f(x) is proportional the index of refraction and depth of the recessed semiconductor material.

26. The device according to claim 20, wherein the processor correlates the curve representing the spectral content of the return signal and the curve representing the theoretical sample spectra with a least squares method.

27. The device according to claim 22, wherein the curve representing the theoretical sample spectra is a second order polynomial mathematically generated by the processor, wherein the processor further subtracts the second order polynomial from the curve representing the spectral content of the return signal.

28. The device according to claim 27, wherein the processor mathematically generates the second order polynomial from the curve representing the spectral content of the return signal.

29. The device according to claim 27, wherein the processor mathematically generates a fit waveform curve, and then compares the fit curve to the curve generated by subtracting the second order polynomial from the curve representing the spectral content of the return signal.

30. The device according to claim 20, wherein the processor mathematically generates a fit waveform curve, and then compares the fit curve to the curve representing the spectral content of the return signal.

31. The device according to claim 30, wherein the processor mathematically generates a second order polynomial from the curve representing the spectral content of the return signal, subtracts the second order polynomial from the curve representing the spectral content of the return signal, normalizes the fit waveform and the curve resulting from subtracting the second order polynomial from the curve representing the spectral content of the return signal, and compares the fit waveform to the curve resulting from subtracting the second order polynomial from the curve representing the spectral content of the return signal.

## FIG. 1

## FIG. 5

FIG. 2 (a)

FIG. 2 (b)

FIG. 2 (c)

FIG. 2 (d)

*FIG. 3*

*FIG. 4*